# EUROPÄISCHE PATENTSCHRIFT

(11) **EP 0 524 947 B1**
(45) Veröffentlichungstag und Bekanntmachung des Hinweises auf die Patenterteilung: **01.06.1994**
(21) Anmeldenummer: 91905119.3
(22) Anmeldetag: 02.03.1991
(51) Int. Cl.: H03H 7/40, A63H 30/04

(54) **SCHALTUNGSANORDNUNG FÜR DEN TANKKREIS EINER MIT FREQUENZUMTASTUNG BETRIEBENEN HOCHFREQUENZ-SENDERENDSTUFE**
CIRCUIT ARRANGEMENT FOR A TANK CIRCUIT OF A HIGH FREQUENCY TRANSMITTER OUTPUT STAGE OPERATED WITH FREQUENCY SHIFT KEYING
CIRCUIT POUR L'ETAGE DE SORTIE FINAL EMETTEUR A HAUTE FREQUENCE FONCTIONNANT PARMANIPULATION DE FREQUENCE

(30) Priorität: 17.04.1990 DE 4012265
(43) Veröffentlichungstag der Anmeldung: 03.02.1993
(73) Patentinhaber: TOPHOLM & WESTERMANN APS, DK-3500 Vaerloese (DK)
(72) Erfinder: ANDERSEN, Henning, Haugaard, DK-2970 Hoersholm (DK)
(74) Vertreter: Böhmer, Hans Erich, Dipl.-Ing.
(86) Internationale Anmeldenummer: EP9100391
(87) Internationale Veröffentlichungsnummer: WO9116762

(56) Entgegenhaltungen:
- GB-A- 994 832
- US-A- 3 395 351

## Beschreibung

Die Erfindung betrifft eine Schaltungsanordnung für den Tankkreis einer mit Frequenzumtastung betriebenen Hochfrequenz-Senderendstufe, mit einer Tankkreiskapazität, einer Tankkreisinduktivität sowie einer Zuführung zum Zuführen von Hochfrequenzenergie an den Tankkreis und mit einem Schalter zum Umschalten des Tankkreises auf Resonanz mit der jeweiligen anderen Sendefrequenz.

Eine derartige Schaltungsanordnung ist beispielsweise aus der US -A-3395 351 bekannt.

Bei dieser Schaltungsanordnung wird die Resonanzfrequenz des Tankkreises durch Zu- oder Abschalten zusätzlicher Induktivität parallel zu Teilen der Tankkreisinduktivität umgeschaltet, wobei die Tankkreisinduktivität einen Übertrager mit einer Primärwicklung und einer Sekundärwicklung enthält, und die Windungszahl der Primärwicklung kleiner ist als die der Sekundärwicklung, die Ausgangssignale des Senders der Primärwicklung zuführbar sind und die Umschaltung des Tankkreises auf die zweite Resonanzfrequenz immer dann erfolgt, wenn die erste Frequenz an der Zuführung der Primärwicklung nicht anliegt.

iese bekannte, recht komplizierte Schaltungsanordnung ist für einen mit Frequenzumtastung arbeitenden Hochfrequenzsender hoher Leistung bestimmt, bei dem es darauf ankommt, die beim Umschalten einer Induktivität erforderliche Steuerleistung erheblich zu reduzieren.

Ferner ist aus der GB - A - 994 832 eine Schaltungsanordnung für die Fernsteuerung von Spielzeugautos innerhalb einer induktiven Drahtschleife bekannt, die Teil eines Schwingkreises ist, der an einen kleinen Sender angeschlossen ist. Der Schwingkreis wird durch eine Anzahl von Kondensatoren vervollständigt, von denen jeweils einer wahlweise angeschaltet werden kann. D.h. die Resonanzfrequenz des aus der induktiven Schleife und jeweils nur einem Kondensator bestehenden Schwingkreises kann wahlweise auf mehrere verschiedene Steuerfrequenzen für die Spielzeugautos umgeschaltet werden.

Bei Sendern der eingangs genannten Art kommt es ganz entscheidend darauf an, daß der Wirkungsgrad des Senders, welcher auch mit durch die Kreisgüte des Tankkreises bestimmt wird, der den Außenwiderstand der Senderendstufe darstellt, möglichst hoch ist.

Bekanntlich werden derartige Hochfrequenzsender normalerweise mit zwei verschiedenen Frequenzen f1 und f2 für die Aussendung von binärkodierten Signalen impulsmäßig getastet, wobei die Impulse mit der einen Frequenz z.B. die binäre "0" und die Impulse der anderen Frequenz die binäre "1" darstellen können. Selbstverständlich sind auch andere Darstellungsarten der Impulsfolgen möglich, solange sie aus zwei verschiedenen Frequenzen bestehen.

Die der Erfindung zugrundeliegende Aufgabe besteht darin, für Senderendstufen der eingangs genannten Art eine optimale Anpassung des Tankkreises oder Ausgangskreises für die beiden Frequenzen beim Betrieb mit Frequenzumtastung sicherzustellen.

Dies wird erfindungsgemäß in der im Patentanspruch 1 gekennzeichneten Weise erreicht. Weitere Ausgestaltungen der Erfindung sind den weiteren Patentansprüchen zu entnehmen.

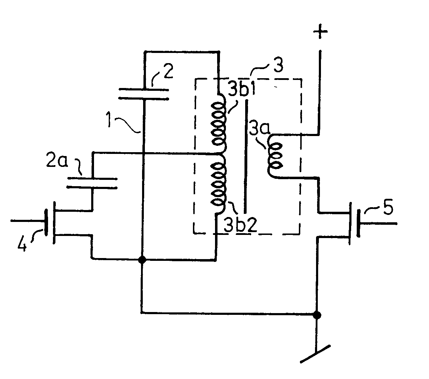

Die Erfindung wird nunmehr anhand eines Ausführungsbeispieles in Prinzipdarstellung in Verbindung mit der beigefügten Zeichnung näher erläutert.

In der Prinzipdarstellung ist ein Tankkreis, d.h. ein Ausgangskreis einer Hochfrequenz-Senderendstufe gezeigt, wie sie beispielsweise bei der Fernsteuerung von Modellen oder dergleichen verwendet werden könnte.

Sender dieser Art haben im allgemeinen eine sehr geringe Leistung, so daß es ganz entscheidend auf einen guten Wirkungsgrad ankommt.

Der Sender soll zum Zwecke der Erläuterung mit Frequenzumtastung zwischen zwei Frequenzen f1 und f2 betriebeh und dafür beschrieben werden. Dabei handelt es sich um Hochfrequen zsignale, deren Frequenzen beispielsweise bei etwa 150 kHz liegen sollen d.h. im Langwellenbereich. Selbstverständlich ist dies keine Beschränkung des Erfindungsgedankens und man wird die Frequenzen entsprechend dem für den jeweiligen Zweck verfügbaren Frequenzbereich auswählen.

Eine dafür geeignete Schaltungsanordnung zeigt die beigefügte Figur im Prinzip. Ein Tankkreis 1 besteht im wesentlichen aus einer Kapazität 2 und einer Induktivität 3, die im vorliegenden Fall aus einem Übertrager mit einer Primärwicklung 3a und einer zwei Wicklungsabschnitte 3b1 und 3b2 aufweisenden Sekundärwicklung 36 besteht. Die Sendeenergie, d.h. die auszusendenden Signale werden der Primärwicklung 3a über einen ersten Schalter 5 zugeführt, der zwischen dem gemeinsamen Fußpunkt der Schaltung und der Primärwicklung 3a eingeschaltet ist. Vorzugsweise ist dieser Schalter ein Feldeffekt-Transistor, der mit den Ausgangssignalen des Senders an seiner Gateelektrode gesteuert wird, während seine Source-Drain-Strecke zwischen dem gemeinsamen Fußpunkt der Schaltung und der an ihrem anderen Ende an dem positiven Pol einer Spannungsquelle angeschlossenen Primärwicklung 3a liegt.

Eine Zusatzkapazität 2a ist an der Anzapfung der Sekundärwicklung 3b angeschlossen. Der der Zu- und Abschaltung der Zusatzkapazität 2a zu einem Teil der Schwingkreisinduktivität dienende zweite Schalter 4, ebenfalls vorzugsweise ein Feldeffekt-Transistor, ist mit seiner Source-Drain-Strecke zwischen dem gemeinsamen Fußpunkt der Schaltung und der Zusatzkapazität 2a eingeschaltet. Dieser Schalter wird zum Zu- oder Abschalten der Zusatzkapazität parallel zu einem Teil der Schwingkreisinduktivität an seiner Gateelektrode so gesteuert, daß der Schalter immer dann geschlossen wird, wenn die erste der beiden Sendefrequenzen am ersten Schalter 5 nicht anliegt, wodurch der Tankkreis auf die zweite Resonanzfrequenz umgeschaltet wird.

Es muß jedoch beachtet werden, daß die an der Sekundärwicklung auftretenden Spannungen je nach Übersetzungsverhältnis des Übertragers 3 leicht mehr als 100 Volt betragen können. Dies könnte zu praktischen Schwierigkeiten führen, da die meisten Feldeffekt-Transistoren derartige Spannungen nicht aushalten können. Bei geeigneter Wahl des Übersetzungsverhältnisses und der Größe der Zusatzkapazität 2a kann man erreichen, daß an dem den Schalter 4 bildenden Feldeffekt-Transistor eine entsprechend geringere Spannung liegt, die dann nicht zu Schwierigkeiten führen kann.

In dem hier ausgeführten Beispiel ist die Kapazität des Kondensators 2a normalerweise ziemlich kleiner als die Kapazität des Kondensators 2. Wenn man aber die Kapazität des zusätzlichen Kondensators 2a etwas größer wählt und diesen sowie den als Schalter 4 wirkenden Feldeffekt-Transistor an die Anzapfung anschließt, dann liegt an diesem Feldeffekt-Transistor eine wesentlich geringere Spannung, die nicht zu Schwierigkeiten führen kann.

Für eine tatsächlich ausgeführte Schaltung kann das Verhältnis der Windungszahlen von Primär- zu Sekundärwicklung zwischen 1 : 10 und 1 : 100 betragen. Die Kapazitätswerte für die Kondensatoren 2 und 2a liegen im einstelligen Nanofarad-Bereich.

Für sehr kleine Sender zur Fernsteuerung von Gerären kann der Tankkreis dadurch sehr kompakt aufgebaut werden, daß die Primärwicklung und die Sekundärwicklung des Übertragers auf einen Ferritkern gewickelt werden, der dann gleichzeitig als Antenne wirkt.

## Patentansprüche

1. Schaltungsanordnung für den Tankkreis (1) einer mit Frequenzumtastung betriebenen Hochfrequenz-Senderendstufe mit einer Tankkreis-Kapazität (2) und einer Tankkreis-Induktivität (3) sowie mit einem ersten Schalter (5) zum Zuführen von Hochfrequenzenergie an den Tankkreis, ferner mit einem zweiten Schalter (4) zum Umschalten des Tankkreises auf Resonanz mit der jeweils anderen Sendefrequenz (f1, f2) durch Zuschalten einer zusätzlichen Kapazität zu Teilen der Tankkreis-Induktivität, die aus einem Übertrager (3) mit einer Primärwicklung (3a) und einer Sekundärwicklung (3b) besteht, wobei die Windungszahl der Primärwicklung kleiner ist als die der Sekundärwicklung, die Ausgangssignale des Senders der Primärwicklung zuführbar sind und die Umschaltung des Tankkreises auf die zweite Resonanzfrequenz immer dann erfolgt, wenn die erste Frequenz an der Zuführung zur Primärwicklung nicht anliegt, wobei die Sekundärwicklung des Übertragers (3) aus zwei Wicklungsabschnitten (3b1, 3b2) mit einer dazwischenliegenden Anzapfung besteht, an der die Zusatzkapazität (2a) angeschlossen ist und der zweite Schalter (4) zwischen der Zusatzkapazität (2a) und einem gemeinsamen Fußpunkt des Tankkreises angeschlossen ist, so daß die Zusatzkapazität (2a) bei geschlossenem zweiten Schalter (4) nur einem Teil (3b2) der Sekundärwicklung (3b) parallel geschaltet ist.

2. Schaltungsanordnung nach Anspruch 1, dadurch gekennzeichnet, daß als zweiter Schalter (4) und als erster Schalter (5) Feldeffekt-Transistoren vorgesehen sind, wobei die Ausgangssignale des Senders an der Gateelektrode des ersten Schalters (5) zugeführt werden, dessen Source-Drain-Strecke zwischen dem gemeinsdmen Fußpunkt des Tankkreises und der mit ihrem anderen Ende an einer positiven Spannungsquelle angeschlossenen Primärwicklung (3a) liegt, während der an seiner Gate-Elektrode steuerbare zweite Schalter (4) mit seiner Source-Drain-Strecke zwischen dem gemeinsamen Fußpunkt des Tankkreises und der an der Anzapfung der Sekundärwicklung (3b1, 3b2) angeschlossenen Zusatzkapazität liegt.

3. Schaltungsanordnung nach Anspruch 1, dadurch gekennzeichnet, daß das Windungsverhältnis der Primärwicklung zur Sekundärwicklung etwa 1 : 10 bis 1 : 100 beträgt.

4. Schaltungsanordnung nach Anspruch 1 bis 3, dadurch gekennzeichnet, daß die Wicklungen (3a, 3b1, 3b2) des Übertragers auf einen Ferritkern gewickelt sind, der als die eigentliche Antenne des Senders wirkt.

## Claims

1. Circuit arrangement for the tank circuit (1) of a high-frequency transmitter-output stage operated with frequency shift keying, equipped with a tank circuit capacitor (2) and a tank circuit inductor (3) and with a first switch (5) for supplying high-frequency energy to the tank circuit, as well as with a second switch (4) for switching the tank circuit to resonance with the other transmission frequency (f1, f2) in each case by connecting an additional capacitor to parts of the tank circuit inductor, the latter consisting of a transformer (3) with a primary winding (3a) and a secondary winding (3b), whereby the number of turns of the primary winding is less than the number of turns of the secondary winding, whereby the output signals of the transmitter can be supplied to the primary winding and whereby switch-over of the tank circuit to the second resonance frequency always occurs when the first frequency is not present at the feeder to the primary winding, whereby the secondary winding of the transformer (3) consists of two winding sections (3b1, 3b2) with an intermediate tap, at which the additional capacitor (2a) is connected, and whereby the second switch (4) is connected between the additional capacitor (2a) and a common base point of the tank circuit so that the additional capacitor (2a) is connected in parallel with only a part (3b2) of the secondary winding (3b) when the second switch (4) is closed.

2. Circuit arrangement in accordance with claim 1, characterized in that field-effect transistors are provided as the second switch (4) and first switch (5), whereby the output signals of the transmitter are supplied to the gate electrode of the first switch (5), whose source-drain connection is located between the common base point of the tank circuit and the primary winding (3a) , whose other end is connected to a positive power source, while the source-drain channel of the second switch (4), which can be controlled at its gate electrode, is located between the common base point of the tank circuit and the additional capacitor connected at the tap of the secondary winding (3b1, 3b2).

3. Circuit arrangement in accordance with claim 1, characterized in that the turn ratio of the primary winding to secondary winding is around 1:10 to 1:100.

4. Circuit arrangement in accordance with claims 1 to 3, characterized in that the windings (3a, 3b1, 3b2) of the transformer are wound onto a ferrite core, which acts as the actual antenna of the transmitter.

## Revendications

1. Circuit pour l'étage de sortie final (1) d'un émetteur haute fréquence fonctionnant par manipulation de fréquence, avec une capacité d'étage de sortie final (2) et une inductance d'étage de sortie final (3) ainsi qu'avec un premier commutateur (5) permettant d'amener l'énergie haute fréquence à l'étage de sortie final ainsi qu'avec un second commutateur (4) permettant de commuter en résonance l'étage de sortie final sur l'autre fréquence d'émission (f1, f2) par la mise en circuit d'une capacité supplémentaire à une part de l'inductance de l'étage de sortie final, composée d'un transformateur (3) avec un enroulement primaire (3a) et un enroulement secondaire (3b), le nombre de spires de l'enroulement primaire étant inférieur à celui de l'enroulement secondaire, les signaux de sortie de l'émetteur pouvant être amenés à l'enroulement primaire et la commutation de l'étage de sortie final sur la seconde fréquence de résonance ayant toujours lieu lorsque la première fréquence n'est pas appliquée à l'enroulement primaire, l'enroulement secondaire du transformateur (3) étant composé de deux portions d'enroulement (3b1, 3b2) entre lesquelles figure une prise à laquelle est reliée la capacité supplémentaire (2a) le second commutateur (4) étant connecté entre la capacité supplémentaire (2a) et une base commune de l'étage de sortie final, si bien que lorsque le second commutateur (4) est fermé, la capacité supplémentaire (2a) n'est en parallèle qu'avec une partie (3b2) de l'enroulement secondaire (3b).

2. Circuit selon la revendication 1, caractérisé en ce que le second commutateur (4) et le premier commutateur (5) sont des transistors à effet de champ, les signaux de sortie de l'émetteur étant appliqués à l'électrode de grille du premier commutateur (5) dont la région source-drain se situe entre la base commune de l'étage de sortie final et l'enroulement primaire (3a) dont l'autre extrémité est reliée à une source de tension positive tandis que la région source-drain du second commutateur (4) dont l'électrode de grille est commandable se situe entre la base commune de l'étage de sortie final et la capacité supplémentaire reliée à la prise de l'enroulement secondaire (3b1, 3b2).

3. Circuit selon la revendication 1, caractérisé en ce que le rapport du nombre de spires de l'enroulement primaire et de l'enroulement secondaire est compris entre 1:10 et 1:100.

4. Circuit selon l'une quelconque des revendications 1 à 3, caractérisé en ce que les enroulements (3a, 3b1, 3b2) du transformateur sont bobinés sur noyau ferrite qui agit comme antenne proprement dite de l'émetteur.
